# EUROPEAN PATENT APPLICATION

(11) **EP 1 484 793 A1**
(43) Date of publication of application: **08.12.2004**
(21) Application number: 03744037.7
(22) Date of filing: 10.03.2003
(51) Int. Cl.: H01L 21/60, H01L 23/12, H01L 25/065, H05K 3/34, H05K 3/46

(54) **ELECTRONIC CIRCUIT DEVICE AND PORDUCTION METHOD THEREFOR**

(30) Priority: 11.03.2002 JP 2002064632; 11.03.2002 JP 2002064666
(71) Applicant: Toyo Kohan Co., Ltd., Tokyo 102-8447 (JP)
(72) Inventor: SAIJO, Kinji, c/o TOYO KOHAN CO., LTD., Kudamatsu-shi, Yamaguchi 744-8611 (JP); YOSHIDA, Kazuo, c/o TOYO KOHAN CO., LTD., Kudamatsu-shi, Yamaguchi 744-8611 (JP); OHSAWA, Shinji, c/o TOYO KOHAN CO., LTD., Kudamatsu-shi, Yamaguchi 744-8611 (JP)
(74) Representative: VOSSIUS & PARTNER
(86) International application number: PCT/JP2003/002784
(87) International publication number: WO 2003/077307

(57) **Abstract**

An electronic circuit device capable of providing a stable electrical connection between an electronic component chip and a connecting multi-layer substrate, and being downsized at high density; and a production method therefor. An electronic component chip (1) and a connecting multi-layer substrate (2) or electronic component chips are heated in an inactive atmosphere such as argon or a reducing atmosphere such as hydrogen and pressure-welded to each other with or without an intermediary of an interposer (6), or their joint surfaces are activated and then pressure-welded at room temperature or by heating, thereby producing an electronic circuit device (40) by directly and metallurgically joining them by using any one of the above methods.

## Description

### Technical Field

The present invention relates to an electronic circuit device, particularly to an electronic circuit device being downsized at high density and a production method thereof.

### Background Art

In recent years, for a mobile phone, a digital video camera, a notebook-size computer and the like, augmented efforts are devoted to downsizing, thinning, lightening and cheapening for the purpose of improving further portability. Therefore, in an electronic circuit device used for these devices and mounted with chips of electronic components such as a semiconductor such as IC, a capacitor (condenser), a resistive element or an inductor on a multi-layer substrate, development studies are proceeded on how to connect electronic component chips to be mounted such as a semiconductor chip to a multi-layer substrate at high density, in addition to downsizing electronic component chips.

As a result, a flip chip mounting method, in which an electronic component chip is directly connected in face down to be mounted on a multi-layer substrate, has been practiced as a mounting method realizing a high density. In the flip chip mounting, connecting electrodes provided to electronic component chips are connected to wiring sections provided on a multi-layer substrate in a block via an electrical connection member such as solder or gold.

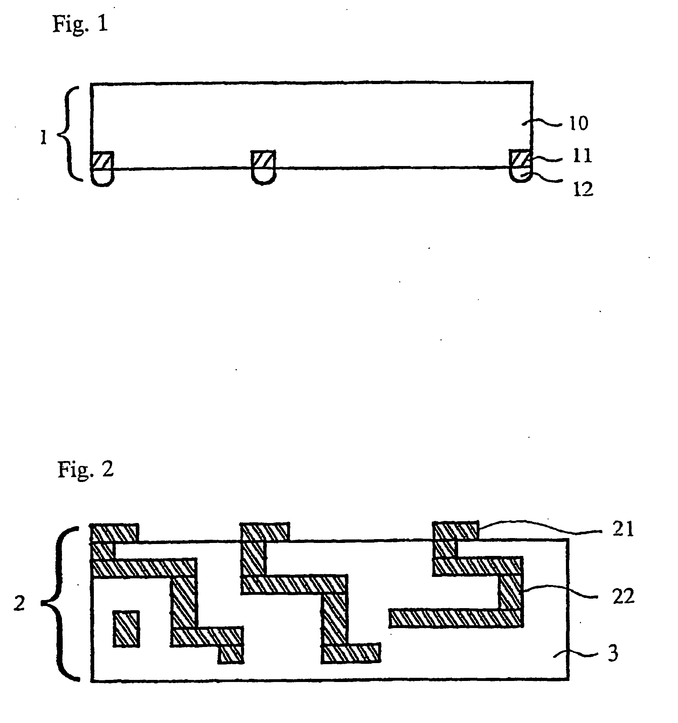

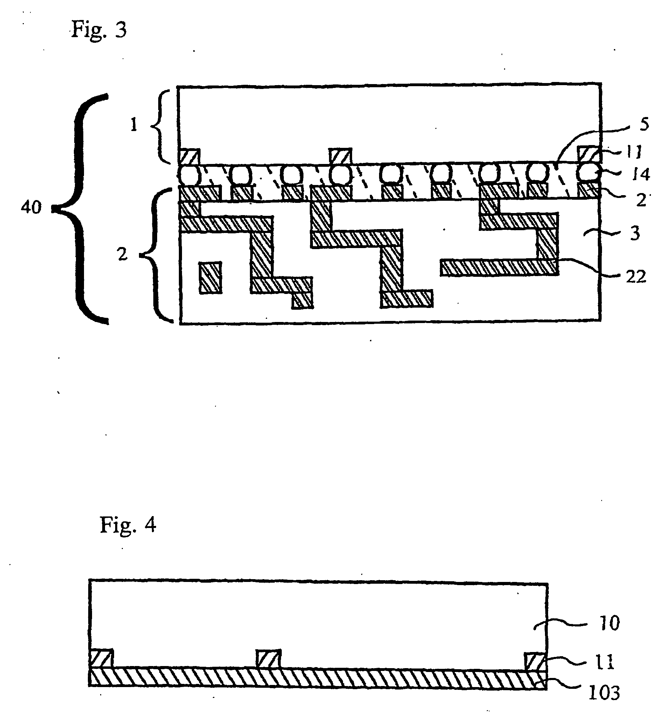

Fig. 3 shows a schematic cross-sectional view of an example of a connection system by the flip chip mounting method in a conventional electronic circuit device. As shown in Fig. 1, electronic component chip 1 comprises electronic component 10, electrode 11 provided on one side thereof and bump 12 consisting of gold or solder for connection formed on electrode 11. As shown in Fig. 2, connecting multi-layer substrate 2 is constituted of multi-layer metal board 3 provided with surface wiring section 21 and interior circuit section 22. And bump 12 of electronic component chip 1 and surface wiring section 21 of connecting multi-layer substrate 2 are abutted via solder ball 14, which are pressurized while heating to a temperature allowing solder 14 to melt to connect electrically electronic component chip 1 and connecting multi-layer substrate 2 via electrode 11, bump 12, solder ball 14 and surface wiring section 21 of the connecting multi-layer substrate. Subsequently, heat-curable sealing resin 5 is injected between solder balls 14 to be heated to cure. In this way, electronic circuit device 40 by the flip chip mounting method as shown in Fig. 3 can be obtained.

However, an electronic circuit device thus flip chip-mounted has such a disadvantage that stable electric connection can not be obtained between the electronic component chip and connecting multi-layer substrate, since a large difference between thermal expansions of curable resin and the bump constituted of a solder ball tends to generate warp during heating to cure the resin, or a crack tends to generate when it is subjected to a rapid temperature variation or mechanical shock to generate joint breakage.

In the invention, it is an object to provide an electronic circuit device being downsized at high density that gives a stable electric connection between an electronic component chip such as a semiconductor chip and a multi-layer substrate, and a production method thereof.

### Disclosure of the Invention

The electronic circuit device according to Claim 1 of the invention is an electronic circuit device constituted by integrating:
an electronic component chip comprising an electronic component and a bump formed on an electrode of the electronic component; and
a connecting multi-layer substrate comprising a multi-layer substrate and an interior circuit section and a surface wiring section formed for the multi-layer substrate and electrically connected with each other,
by joining directly the bump formed on the electrode of the electronic component to the surface wiring section.

In addition, the electronic circuit device according to Claim 2 is an electronic circuit device constituted by integrating:
an electronic component chip; and
a connecting multi-layer substrate comprising a multi-layer substrate, an interior circuit section and a surface wiring section formed for the multi-layer substrate and electrically connected with each other, and a bump formed on the surface wiring section,
by joining directly an electrode of an electronic component to the bump formed on the surface wiring section.

Further, the electronic circuit device according to Claim 3 is an electronic circuit device constituted by integrating:
an electronic component chip with an interposer constituted of an electronic component chip comprising an electronic component and a bump formed on an electrode of the electronic component, and an interposer including surface wiring sections electrically connected with each other for a substrate, through joining directly the surface wiring section on one side of the substrate of the interposer to the bump formed on the electrode of the electronic component; and
a connecting multi-layer substrate comprising a multi-layer substrate and an interior circuit section and surface wiring section formed for the multi-layer substrate and electrically connected with each other,
by joining the surface wiring section of the interposer to the surface wiring section of the multi-layer substrate via a solder ball.

Further, the electronic circuit device according to Claim 4 is an electronic circuit device constituted by integrating:
an electronic component chip with an interposer constituted of an electronic component chip and an interposer comprising surface wiring sections electrically connected with each other for a substrate and a bump formed on the surface wiring section, through joining directly the bump formed on the surface wiring section of one side of the substrate of the interposer to an electrode of an electronic component; and
a connecting multi-layer substrate comprising a multi-layer substrate and an interior circuit section and surface wiring section formed for the multi-layer substrate and electrically connected with each other,
by joining the surface wiring section of the interposer to the surface wiring section of the multi-layer substrate via a solder ball.

Further, the electronic circuit device according to Claim 5 is an electronic circuit device constituted by integrating:
a first electronic component chip comprising a first electronic component and a bump formed on an electrode of the first electronic component;
an interposer having surface wiring sections electrically connected with each other for a substrate; and
a second electronic component chip comprising a second electronic component and a bump formed on an electrode of the second electronic component,
by joining directly the bump on the electrode of the first electronic component to the surface wiring section of one side of the interposer, and the surface wiring section of the other side of the interposer to the bump on the electrode of the second electronic component, respectively.

Further, the electronic circuit device according to Claim 6 is an electronic circuit device constituted by integrating:
a first electronic component chip;
an interposer comprising surface wiring sections electrically connected with each other for a substrate and a bump formed on the surface wiring section; and
a second electronic component chip comprising a second electronic component and a bump formed on an electrode of the second electronic component,
by joining directly the electrode of the first electronic component to the bump on the surface wiring section of one side of the interposer, and the surface wiring section of the other side of the interposer to the bump on the electrode of the second electronic component, respectively.

Further, the electronic circuit device according to Claim 7 is an electronic circuit device constituted by integrating:
a first electronic component chip;
an interposer comprising surface wiring sections electrically connected with each other for a substrate and a bump formed on the surface wiring section; and
a second electronic component chip,
by joining directly an electrode of a first electronic component to the bump on the surface wiring section of one side of the interposer, and the bump on the surface wiring section of the other side of the interposer to an electrode of a second electronic component, respectively.

In addition, an electronic circuit device according to any of claims 1 to 7, characterized in that an electronic component is any of a semiconductor, a capacitor, a resistive element or an inductor; and further
an electronic circuit device according to any of claims 1 to 7, characterized in that a figure of the bump is a truncated cone or a truncated pyramid having a length of a diameter of the top or a diagonal line of the top of 10 % or more of the height of the bump.

The production method of an electronic circuit device according to Claim 10 of the invention is a production method of an electronic circuit device characterized by integrating:
an electronic component chip comprising an electronic component and a bump formed on an electrode of the electronic component; and
a connecting multi-layer substrate comprising a multi-layer substrate and an interior circuit section and surface wiring section formed for the multi-layer substrate and electrically connected with each other,
by joining directly the bump formed on the electrode of the electronic component to the surface wiring section.

In addition, the production method of an electronic circuit device according to Claim 11 is a production method of an electronic circuit device characterized by integrating:
an electronic component chip; and
a connecting multi-layer substrate comprising a multi-layer substrate, an interior circuit section and surface wiring section formed for the multi-layer substrate and electrically connected with each other, and a bump formed on the surface wiring section,
by joining directly an electrode of an electronic component to the bump formed on the surface wiring section.

Further, the production method of an electronic circuit device according to Claim 12 is a production method of an electronic circuit device characterized by integrating:
an electronic component chip with an interposer constituted of an electronic component chip comprising an electronic component and a bump formed on an electrode of the electronic component and an interposer having a substrate with surface wiring sections electrically connected with each other, through joining directly the surface wiring section of one side of the substrate of the interposer to the bump formed on the electrode of the electronic component,
by joining the surface wiring section of the interposer, via a solder ball, to a connecting multi-layer substrate comprising a multi-layer substrate and an interior circuit section and surface wiring section formed for the multi-layer substrate and electrically connected with each other.

Further, the production method of an electronic circuit device according to Claim 13 is a production method of an electronic circuit device characterized by integrating:
an electronic component chip with an interposer constituted of an electronic component chip and an interposer comprising surface wiring sections electrically connected with each other for a substrate and bumps formed on the surface wiring sections through joining directly the bump formed on the surface wiring section of one side of the substrate of the interposer to an electrode of an electronic component,
by joining the surface wiring section of the interposer, via a solder ball, to a connecting multi-layer substrate comprising a multi-layer substrate and an interior circuit section and surface wiring section formed for the multi-layer substrate and electrically connected with each other.

Further, the production method of an electronic circuit device according to Claim 14 is a production method of an electronic circuit device characterized by integrating:
a first electronic component chip comprising a first electronic component and a bump formed on an electrode of the first electronic component;
an interposer comprising surface wiring sections electrically connected with each other on both sides of a substrate; and
a second electronic component chip comprising a second electronic component and a bump formed on an electrode of the second electronic component,
by joining directly the bump on the electrode of the first electronic component to the surface wiring section of one side of the interposer, and the surface wiring section of the other side of the interposer to the bump on the electrode of the second electronic component, respectively.

Further, the production method of an electronic circuit device according to Claim 15 is a production method of an electronic circuit device characterized by integrating:
a first electronic component chip;
an interposer comprising surface wiring sections electrically connected with each other for a substrate and a bump formed on the surface wiring section; and
a second electronic component chip comprising a second electronic component and a bump formed on an electrode of the second electronic component,
by joining directly an electrode of a first electronic component to the bump on one side of the surface wiring section of the interposer, and the surface wiring section of the other side of the interposer to the bump on the electrode of the second electronic component, respectively.

Further, the production method of an electronic circuit device according to Claim 16 is a production method of an electronic circuit device characterized by integrating:
a first electronic component chip;
an interposer comprising surface wiring sections electrically connected with each other for a substrate and a bump formed on the surface wiring section; and
a second electronic component chip,
by joining directly an electrode of a first electronic component to the bump on the surface wiring section of one side of the interposer, and the bump on the surface wiring section of the other side of the interposer to an electrode of a second electronic component, respectively.

In addition, the production method of an electronic circuit device according to any of Claims 10 to 16, characterized in that the direct joining is carried out by heating in an inactive atmosphere or a reducing atmosphere to 200 to 300 °C and pressure-welding (Claim 17); or
by cold-rolling at ordinary temperatures after a previous activation treatment of the joint surfaces (Claim 18) .

And the production method of an electronic circuit device according to Claim 18 is characterized in that the activation treatment is carried out by irradiating any of plasma, ions or atoms in a vacuum chamber; or
the pressure-welding is carried out either at room temperature or by heating.

### Brief Description of the Drawings

Fig. 1 is a schematic cross-sectional view illustrating an example of an electronic component chip to which a conventional bump is formed;
Fig. 2 is a schematic cross-sectional view illustrating an example of a connecting multi-layer substrate;
Fig. 3 is a schematic cross-sectional view illustrating an example of connection system of a conventional electronic circuit device;
Fig. 4 is a schematic cross-sectional view illustrating an example of a state at one step of the production process of the electronic component chip according to the invention;
Fig. 5 is a schematic cross-sectional view illustrating an example of the electronic component chip according to the invention;
Fig. 6 is a schematic cross-sectional view illustrating an example of a state at one step of another production process of the electronic component chip according to the invention;
Fig. 7 is a schematic cross-sectional view illustrating an example of a state at another step of another production process of the electronic component chip according to the invention;
Fig. 8 is a schematic cross-sectional view illustrating another example of the electronic component chip according to the invention;
Fig. 9 is a schematic cross-sectional view illustrating an example of the connection system of the electronic circuit device according to the invention;
Fig. 10 is a schematic cross-sectional view illustrating another example of the connection system of the electronic circuit device according to the invention;
Fig. 11 is a schematic cross-sectional view illustrating another example of the connection system of the electronic circuit device according to the invention; and
Fig. 12 is a schematic cross-sectional view illustrating the cross-sectional figure of the bump of the electronic circuit device according to the invention.

### Best Mode for Carrying out the Invention

Hereinafter, the invention will be described in detail with reference to the drawings.

### (Embodiment 1)

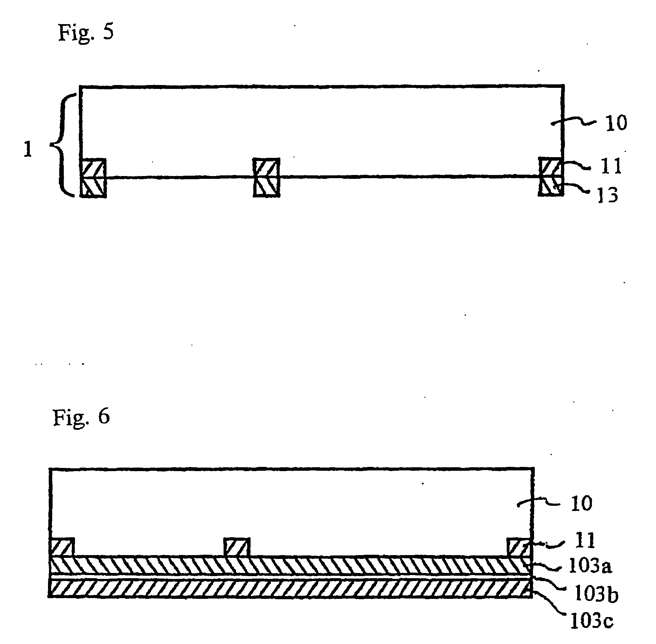

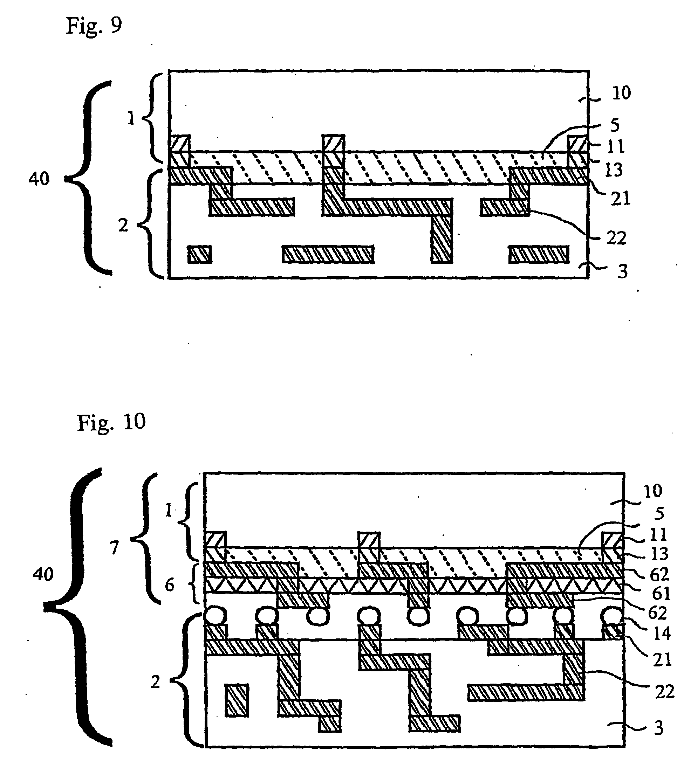

Fig. 9 is a schematic cross-sectional view of the electronic circuit device according to Claim 1 of the invention: In the figure, electronic component chip 1 (for example, a semiconductor chip) , which is a chip of any of a semiconductor, a capacitor, a resistive element or an inductor, comprises electronic component 10 (for example, a semiconductor, or any of following electronic components other than the semiconductor), which is any of a semiconductor, a capacitor, a resistive element or an inductor, electrode 11 provided on one side thereof and bump 13 formed on electrode 11. Through joining directly this to surface wiring section 21 of connecting multi-layer substrate 2, electronic circuit device 40 is constituted. Bump 13 of electronic component chip 1 that is joined directly to surface wiring section 21 of connecting multi-layer substrate 2 can be formed by patterning with a resist so as to expose the part of electrode 11 alone, mounding a layer to be bump 13 on electrode 11 by using an electrode plating method, and then removing the resist. Also, it can be formed in the manner as shown in Figs. 4 and 5. That is, by utilizing the method disclosed in Domestic Re-publication of PCT patent Application WO 99/58470 wherein surfaces to be adhered are subjected to an activation treatment and then the treated surfaces are pressure-welded, the surface of electronic component chip 1 including electrode 11 and the surface of copper foil to be adhered, which will constitute conductive layer 103, are subjected to an activation treatment followed by pressure-welding lamination to form conductive layer 103, subsequently bump 13 is formed on electrode 11 by utilizing an etching method.

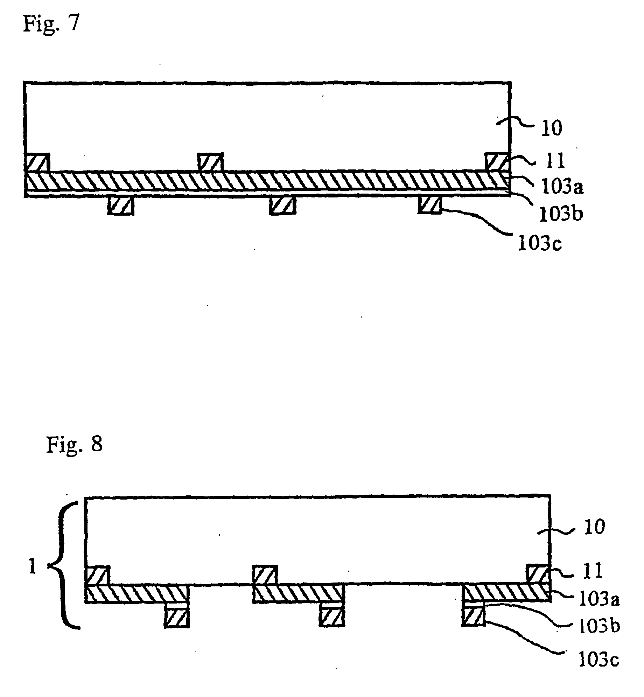

A bump of electronic component chip 1 that is joined directly to surface wiring section 21 of connecting multi-layer substrate 2 can be also formed in the manner as shown in Figs. 6 to 8. That is, conductive layer 103a consisting of copper is formed on the surface of electronic component chip 1 including electrode 11 by utilizing an evaporation method or the like followed by forming etching stop layer 103b consisting of nickel thereon by utilizing a publicly known plating method, evaporation method or the like. And further thereon, conductive layer 103c consisting of copper is formed in the same manner as described for the etching stop layer 103b consisting of nickel. Alternatively, after forming conductive layer 103a consisting of copper on the surface of electronic component chip 1 including electrode 11 and, by utilizing the joint technique of metal foils as disclosed in Domestic Re-publication of PCT patent Application WO 00/19533, the joint surfaces of a nickel foil material forming etching stop layer 103b and a copper foil material forming conductive layer 103c are previously subjected to an activation treatment in a vacuum chamber followed by laminating and cold welding the copper foil and nickel foil to form a cladding board. Then, the nickel surface of the cladding board and the aforementioned conductive layer 103a surface provided on electronic component chip 1 are subjected to an activation treatment in a vacuum chamber followed by laminating and cold welding the cladding board and electronic component chip 1 to form three layers constituted of conductive layer 103a consisting of copper, etching stop layer 103b consisting of nickel and conductive layer 103c consisting of copper. Alternatively, by utilizing the joint technique of metal foils as disclosed in Domestic Re-publication of PCT patent Application WO 00/19533, a cladding material of three layers constituted of conductive layer 103a, etching stop layer 103b and conductive layer 103c may be formed, which is pressure-welded and laminated to the surface of electronic component chip 1 including electrode 11 by utilizing a pressure-welding method as disclosed in Domestic Re-publication of PCT patent Application WO 99/58470.

Through selectively etching the three layers thus obtained, it is also possible to form, to electronic component chip 1, bump 103c electrically connected from electrode 11 via surface wiring section 103a and nickel section 103b at a position dislocated from electrode 11.

On the other hand, regarding connecting multi-layer substrate 2, the base may be formed by utilizing a conventional buildup method. Alternatively, it may be constituted by utilizing the joint technique of metal foils as disclosed in Domestic Re-publication of PCT patent Application WO 00/05934 and a selective etching method in the similar way to the case of electronic component chip 1 to form a base, providing an insulative layer and surface wiring section 21 on the base surface, then electrically connecting surface wiring section 21 and interior circuit section 22. Subsequently, as shown in Fig. 9, surface wiring section 21 of connecting multi-layer substrate 2 is abutted directly and joined with bump 13 of electronic component chip 1 to give electronic circuit device 40.

Regarding the joining method, they can be joined directly and metallurgically by utilizing either of the following methods:
1) pressure-welding is performed in an inactive atmosphere such as argon or in a reducing atmosphere such as hydrogen while heating to 200 to 300 °C; and
2) joint surfaces are activated previously by irradiating atoms followed by pressure-welding at room temperature or while heating to 200 to 300 °C. The activation treatment is possible by irradiation of plasma or ions. However, since irradiation of plasma or ions may charge members to destroy, atom irradiation is preferred. Subsequently, sealing resin 5 is filled around bump 13. In this connection, although bump 13 is provided to the electrode 11 of electronic component chip 1 in the aforementioned constitution, the bump may be provided to surface wiring section 21 of connecting multi-layer substrate 2; or bumps may be provided to both of electrode 11 of electronic component chip 1 and surface wiring section 21 of connecting multi-layer substrate 2.

### (Embodiment 2)

Fig. 10 is a schematic cross-sectional view of the electronic circuit device according to Claim 3 of the invention. In this figure, firstly, electronic component chip 1 to which bump 13 is formed in the same manner as described in Embodiment 1 is joined directly with interposer 6. That is, interposer 6 is constituted of a substrate 61 made of a heat-resistant resin to which surface wiring sections 62 being electrically connected with each other are formed. Surface wiring section 62 of one side of interposer 6 is abutted to bump 13 of electronic component chip 1, which are directly joined in the same manner as described in Embodiment 1 to constitute electronic component chip 7 with the interposer.

On the other hand, connecting multi-layer substrate 2 is constituted in the same manner as shown in Fig. 9. Surface wiring section 21 of connecting multi-layer substrate 2 is abutted via solder ball 14 to surface wiring section 62 of the side to be joined with connecting multi-layer substrate 2 of interposer 6 of semiconductor chip 7 with the interposer constituted in the aforementioned manner, which are heated to a temperature capable of melting solder 14 and pressed to connect electrically surface wiring section 62 of the interposer with surface wiring section 21 of the connecting multi-layer substrate via solder ball 14. In this way, electronic circuit device 40 can be obtained. In this connection, in the aforementioned constitution, although bump 13 is provided to electrode 11 of electronic component chip 1, a bump may be provided to surface wiring section 62 of interposer 6; or bumps may be provided to both of electrode 11 and surface wiring section 62 of interposer 6.

In the aforementioned Embodiment, an example of the electronic circuit device, in which the connecting multi-layer substrate is joined directly or via the interposer with the electronic component chip, is shown. However, there may be such a case as an electronic circuit device that is constituted by joining respective electronic component chips (for example, a semiconductor chip and another semiconductor chip, a semiconductor chip and resistive element chip, etc.). Hereinafter, an example of an electronic circuit device constituted by joining respective electronic component chips will be described.

### (Embodiment 3)

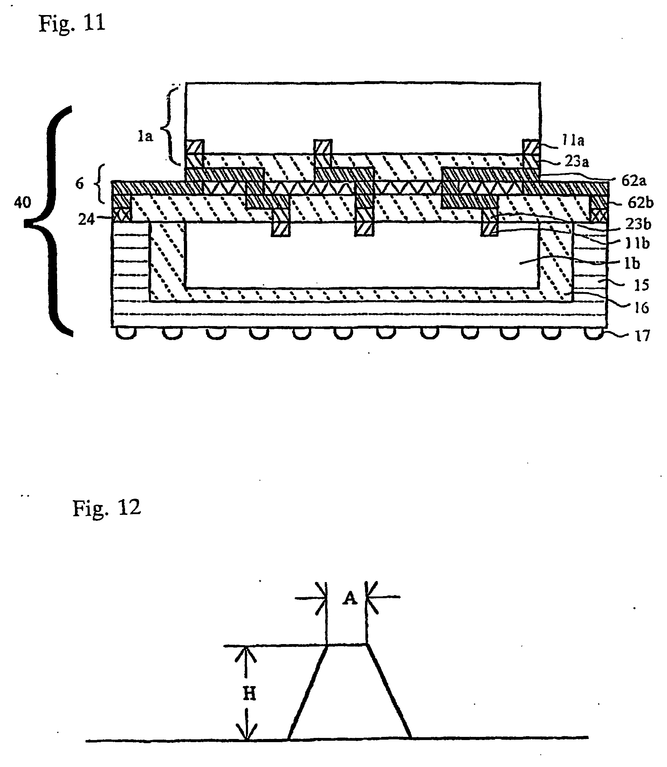

Fig. 11 is a schematic cross-sectional view of the electronic circuit device according to Claim 5 of the invention. The figure represents the case where respective electronic component chips are joined via an interposer. In this figure, firstly bump 23a of electrode 11a of a first electronic component chip 1a to be one electronic component chip is abutted to surface wiring section 62a provided to one side of interposer 6, which are joined directly in the same manner as described in Embodiment 1. Subsequently, bump 23b of electrode 11b of a second electronic component chip 1b to be the other electronic component chip is abutted to surface wiring section 62b provided to the other side of interposer 6, which are joined directly in the same manner as described in Embodiment 1. In this way, respective electronic component chips can be connected electrically via the interposer on both sides thereof. In addition, as shown in Fig. 11, surface wiring section 62b of one side of interposer 6 is abutted and joined with bump 24 provided to one side of connecting multi-layer substrate 15 to connect electrically with connecting multi-layer substrate 15. Subsequently, sealing resin 16 is injected between connecting multi-layer substrate 15 and a second electronic component chip 1b and heated to cure. A surface wiring section (not shown) provided to the other side of connecting multi-layer substrate 15 is provided with bump 17, which makes it possible to connect with another multi-layer substrate, electronic component chip or the like (not shown). In this way, electronic circuit device 40 which is constituted by joining respective electronic component chips can be obtained.

In this connection, although bump 23a for joining is provided to electrode 11a of the first electronic component chip 1a, the bump may be provided to surface wiring section 62a of interposer 6, or bumps may be provided to both of the first electronic component chip 1a and interposer 6. Further, although bump 23b for joining is provided to electrode 11b of the second electronic component chip 1b, the bump may be provided to surface wiring section 62b of interposer 6, or bumps may be provided to both of the second electronic component chip 1b and interposer 6. Furthermore, although bump 24 for joining is provided to connecting multi-layer substrate 15, the bump may be provided to electrode 11b of the second electronic component chip 1b or bumps may be provided to both of connecting multi-layer substrate 15 and second electronic component chip 1b.

In the invention, the figure of the bump formed in Embodiments 1 to 3 is preferably either a truncated cone or a truncated pyramid, and length A of the diameter of the top or the diagonal line of the top is 10 % or more of height H of the bump, as shown in Fig. 12. A small area of the top of the bump in this way results in a large loaded pressure per unit area at joining to improve stability of the joining. The invention intends an electronic circuit device being downsized at high density, and the height of the bump is 200 µm at the highest. Therefore it is difficult to make the length of the diameter of the top or the diagonal line of the top of the bump extremely small, and the lower limit of the length is 10 % of the height of the bump.

### Industrial Applicability

As shown in Embodiments 1 to 3, in the electronic circuit device according to the invention, the electronic component chip and connecting multi-layer substrate, or respective electronic component chips are joined directly and metallurgical with or without an interposer to give a stable electric connection. Further, the figure of the bump is a truncated cone or a truncated pyramid having a length of the diameter of the top or the diagonal line of the top of 10 % or more of the height of the bump. A small area of the top of the bump in this way results in a large loaded pressure per unit area at joining to improve stability of the joining. Accordingly, the electronic circuit device according to the invention has an especially excellent actuation reliability.

## Claims

1. An electronic circuit device constituted by integrating:
an electronic component chip comprising an electronic component and a bump formed on an electrode of the electronic component; and
a connecting multi-layer substrate comprising a multi-layer substrate and an interior circuit section and surface wiring section formed for the multi-layer substrate and electrically connected with each other,
by joining directly the bump formed on the electrode of the electronic component to the surface wiring section.

2. An electronic circuit device constituted by integrating:
an electronic component chip; and
a connecting multi-layer substrate comprising a multi-layer substrate, an interior circuit section and a surface wiring section formed for the multi-layer substrate and electrically connected with each other and a bump formed on the surface wiring section,
by joining directly an electrode of an electronic component to the bump formed on the surface wiring section.

3. An electronic circuit device constituted by integrating:
an electronic component chip with an interposer constituted of an electronic component chip comprising an electronic component and a bump formed on an electrode of the electronic component, and an interposer including surface wiring sections electrically connected with each other for a substrate, through joining directly the surface wiring section on one side of the substrate of the interposer to the bump formed on the electrode of the electronic component; and
a connecting multi-layer substrate comprising a multi-layer substrate and an interior circuit section and surface wiring section formed for the multi-layer substrate and electrically connected with each other,
by joining the surface wiring section of the interposer to the surface wiring section of the multi-layer substrate via a solder ball.

4. An electronic circuit device constituted by integrating:
an electronic component chip with an interposer constituted of an electronic component chip and an interposer comprising surface wiring sections electrically connected with each other for a substrate and a bump formed on the surface wiring section, through joining directly the bump formed on the surface wiring section of one side of the substrate of the interposer to an electrode of an electronic component; and
a connecting multi-layer substrate comprising a multi-layer substrate and an interior circuit section and surface wiring section formed for the multi-layer substrate and electrically connected with each other,
by joining the surface wiring section of the interposer to the surface wiring section of the multi-layer substrate via a solder ball.

5. An electronic circuit device constituted by integrating:
a first electronic component chip comprising a first electronic component and a bump formed on an electrode of the first electronic component;
an interposer having surface wiring sections electrically connected with each other for a substrate; and
a second electronic component chip comprising a second electronic component and a bump formed on an electrode of the second electronic component,
by joining directly the bump on the electrode of the first electronic component to the surface wiring section of one side of the interposer, and the surface wiring section of the other side of the interposer to the bump on the electrode of the second electronic component, respectively.

6. An electronic circuit device constituted by integrating:
a first electronic component chip;
an interposer comprising surface wiring sections electrically connected with each other for a substrate and a bump formed on the surface wiring section; and
a second electronic component chip comprising a second electronic component and a bump formed on an electrode of the second electronic component,
by joining directly the electrode of the first electronic component to the bump on the surface wiring section of one side of the interposer, and the surface wiring section of the other side of the interposer to the bump on the electrode of the second electronic component, respectively.

7. An electronic circuit device constituted by integrating:
a first electronic component chip;
an interposer comprising surface wiring sections electrically connected with each other for a substrate and a bump formed on the surface wiring section; and
a second electronic component chip,
by joining directly an electrode of a first electronic component to the bump on the surface wiring section of one side of the interposer, and the bump on the surface wiring section of the other side of the interposer to an electrode of a second electronic component, respectively.

8. The electronic circuit device according to any of Claims 1 to 7, wherein the electronic component is any of a semiconductor, a capacitor, a resistive element or an inductance.

9. The electronic circuit device according to any of Claims 1 to 7, **characterized in that** a figure of the bump is a truncated cone or a truncated pyramid having a length of a diameter of the top or a diagonal line of the top of 10 % or more of the height of the bump.

10. A production method of an electronic circuit device **characterized by** integrating:
an electronic component chip comprising an electronic component and a bump formed on an electrode of the electronic component; and
a connecting multi-layer substrate comprising a multi-layer substrate and an interior circuit section and surface wiring section formed for the multi-layer substrate and electrically connected with each other,
by joining directly the bump formed on the electrode of the electronic component to the surface wiring section.

11. A production method of an electronic circuit device **characterized by** integrating:
an electronic component chip; and
a connecting multi-layer substrate comprising a multi-layer substrate, an interior circuit section and surface wiring section formed for the multi-layer substrate and electrically connected with each other, and a bump formed on the surface wiring section,
by joining directly an electrode of an electronic component to the bump formed on the surface wiring section.

12. A production method of an electronic circuit device **characterized by** integrating:
an electronic component chip with an interposer constituted of an electronic component chip comprising an electronic component and a bump formed on an electrode of the electronic component and an interposer having a substrate with surface wiring sections electrically connected with each other, through joining directly the surface wiring section of one side of the substrate of the interposer to the bump formed on the electrode of the electronic component,
by joining the surface wiring section of the interposer, via a solder ball, to a connecting multi-layer substrate comprising a multi-layer substrate and an interior circuit section and surface wiring section formed for the multi-layer substrate and electrically connected with each other.

13. A production method of an electronic circuit device **characterized by** integrating:
an electronic component chip with an interposer constituted of an electronic component chip and an interposer comprising surface wiring sections electrically connected with each other for a substrate and bumps formed on the surface wiring sections through joining directly the bump formed on the surface wiring section of one side of the substrate of the interposer to an electrode of an electronic component,
by joining the surface wiring section of the interposer, via a solder ball, to a connecting multi-layer substrate comprising a multi-layer substrate and an interior circuit section and surface wiring section formed for the multi-layer substrate and electrically connected with each other.

14. A production method of an electronic circuit device **characterized by** integrating:
a first electronic component chip comprising a first electronic component and a bump formed on an electrode of the first electronic component;
an interposer comprising surface wiring sections electrically connected with each other for a substrate; and
a second electronic component chip comprising a second electronic component and a bump formed on an electrode of the second electronic component,
by joining directly the bump on the electrode of the first electronic component to the surface wiring section of one side of the interposer, and the surface wiring section of the other side of the interposer to the bump on the electrode of the second electronic component, respectively.

15. A production method of an electronic circuit device **characterized by** integrating:
a first electronic component chip;
an interposer comprising surface wiring sections electrically connected with each other for a substrate and a bump formed on the surface wiring section; and
a second electronic component chip comprising a second electronic component and a bump formed on an electrode of the second electronic component,
by joining directly an electrode of a first electronic component to the bump on one side of the surface wiring section of the interposer, and the surface wiring section of the other side of the interposer to the bump on the electrode of the second electronic component, respectively.

16. A production method of an electronic circuit device **characterized by** integrating:
a first electronic component chip;
an interposer comprising surface wiring sections electrically connected with each other for a substrate and a bump formed on the surface wiring section; and
a second electronic component chip,
by joining directly an electrode of a first electronic component to the bump on the surface wiring section of one side of the interposer, and the bump on the surface wiring section of the other side of the interposer to an electrode of a second electronic component, respectively.

17. The production method of an electronic circuit device according to any of Claims 10 to 16, **characterized in that** the direct joining is carried out by heating in an inactive atmosphere or a reducing atmosphere to 200 to 300 °C and pressure-welding.

18. The production method of an electronic circuit device according to any of Claims 10 to 16, **characterized in that** the direct joining is carried out by pressure-welded after a previous activation treatment of the joint surfaces.

19. The production method of an electronic circuit device according to Claim 18, **characterized in that** the activation treatment is carried out by irradiating any of plasma, ions or atoms in a vacuum chamber.

20. The production method of an electronic circuit device according to Claim 18, **characterized in that** the pressure-welding is carried out either at room temperature or by heating.
